Europäisches Patentamt

European Patent Office

Office européen des brevets

(19)

(11) Publication number: **0 200 221 B1**

## EUROPEAN PATENT SPECIFICATION

(12)

(45) Date of publication of patent specification: **08.07.92**

(51) Int. Cl.⁵: **H05K 7/20**

(21) Application number: **86105963.2**

(22) Date of filing: **30.04.86**

(54) Evaporation cooling module for semiconductor devices.

(30) Priority: **30.04.85 JP 92511/85**
**09.10.85 JP 225211/85**

(43) Date of publication of application:
**05.11.86 Bulletin 86/45**

(45) Publication of the grant of the patent:
**08.07.92 Bulletin 92/28**

(84) Designated Contracting States:
**DE FR GB IT NL**

(56) References cited:
**EP-A- 0 007 015**
**EP-A- 0 167 665**
**US-A- 3 512 582**

(73) Proprietor: **FUJITSU LIMITED**
**1015, Kamikodanaka Nakahara-ku**
**Kawasaki-shi Kanagawa 211(JP)**

(72) Inventor: **Yokouchi, Kishio**
**1-26-402 Sagamigaoka 2 chome**
**Zama-shi Kanagawa, 228(JP)**
Inventor: **Suzuki, Yuichi**
**9-2-212 Kamitsuruma 7 chome**
**Sagamihara-shi Kanagawa, 228(JP)**
Inventor: **Niwa, Koichi**
**34-7-3 Nagayama 5 chome**
**Tama-shi Tokyo, 206(JP)**

(74) Representative: **Greenstreet, Cyril Henry et al**
**Haseltine Lake & Co. Hazlitt House 28 South-**
**ampton Buildings Chancery Lane**
**London WC2A 1AT(GB)**

## Description

The present invention relates to a cooling module for semiconductor devices as defined in claims 1 and 7 in which a plurality of semiconductor chips mounted on a circuit board are immersed in a coolant liquid, evaporation cooling is applied and the evaporated coolant vapour is liquefied again by a heat exchanger immersed in the coolant.

The following articles are representative of the prior art in the area of liquid cooling modules for a plurality of heating elements. Most of them disclose a method for cooling plurality of packaged devices immersed in coolant, but they are applicable in principle to cooling semiconductor chips immersed directly into the coolant.

"Dielectric bath promotes togetherness in IC's" by R.R.Weirather et al, Electronics, April 17, 1967: describes fundamentals of cooling plenty of substrates immersed in a liquid-cooling housing.

"Better component cooling through multi fluid boiling" by Sevgin Oktay, Electronic Packaging and Production, May 1970: discloses a fundamentals of cooling a first coolant liquid which immerses the heating elements by a second coolant.

U.S.Patent 3,741,292 of Akalau et al, June 26, 1973: discloses a module including heat generating components exposed inside a container including low temperature boiling liquid.

U.S.Patent 3,851,221 of Beaulieu et al, Nov. 26,1974: discloses a package having a plurality of substrates in a stack immersed in coolant.

Japanese laid open patents 47-37181 of Yanatori, 49-98583 of Daikoku, and 55-91197 of Fujii: disclose a bubble handling guide plate provided in coolant to make the bubbles of coolant go up along the inner surface of the package sealing the coolant, to increase the cooling efficiency.

U.S. Patent 3 512 582 discloses an evaporation cooling module for cooling a plurality of electronic components mounted vertically on a circuit board immersed in a coolant, comprising a case for sealing said coolant, one or more heat exchangers for cooling said coolant and liquefying evaporated coolant vapour, said heat exchanger(s) being immersed in said coolant and having fins projecting laterally therefrom for increasing the surface for contact between bubbles of evaporated vapour of said coolant and said heat exchanger(s). Deflectors may be provided above each electronic component to deflect bubbles into the adjacent finned area of the heat exchanger.

As the packing density of circuit elements in electronic equipment increases it has become important to remove the dissipated heat in the equipment, and the cooling method has proceeded from air cooling to liquid cooling. Various kinds of cooling methods have been proposed and improved. At first, a cooling pipe was coupled to a circuit board or coupled directly to a heat generating element. But as the packing density of circuit elements and heat dissipation have further increased, the circuit board itself has been immersed in a coolant liquid.

In an early stage of liquid immersion cooling, the circuit elements were each encapsulated in a hermetic case and fitted on a circuit board, then immersed in the coolant. But progress of surface passivation of circuit elements made it possible to immerse them in coolant without packages, and this further increased the cooling efficiency and the packing density. For instance, in computers using many integrated circuits (ICs), it became possible to mount a plurality of IC chips directly on a ceramic circuit board without packages, and immerse them into a liquid coolant. This has been made possible by improved surface passivation of IC chips. Recently a plurality of semiconductor chips have been grouped and bonded on a sub circuit board, which is then bonded to a main or mother circuit board. Such a sub circuit board carrying a plurality of chips is called in the art a chip. The present invention does not exclude the cooling of such sub circuit boards. In the following description and claims, therefore, the word chip is used to mean an individual chip or a sub circuit board carrying a plurality of chips.

On the other hand, it is known that the cooling efficiency is better for evaporation cooling that boils the coolant at the surface of a heating element than convection cooling, though the temperature of the heating element becomes higher. By choosing a coolant liquid having a lower boiling point, it is possible to keep the temperature of the heating element sufficiently low. IC chips can stand a temperature of $80\,^{\circ}C$ for example, so using a liquid having a boiling point less than $80\,^{\circ}C$, it is possible to realize an evaporation cooling.

Coolant used for such purpose must be noncorrosive and electric insulating. Freon ($C_2Cl_3F_3$) having boiling point of $49\,^{\circ}C$ or various fluorocarbons such as $C_5F_{12}$ having boiling point of $30\,^{\circ}C$, and $C_6F_{14}$ having boiling point of $56\,^{\circ}C$ are applicable for immersion cooling of semiconductor chips.

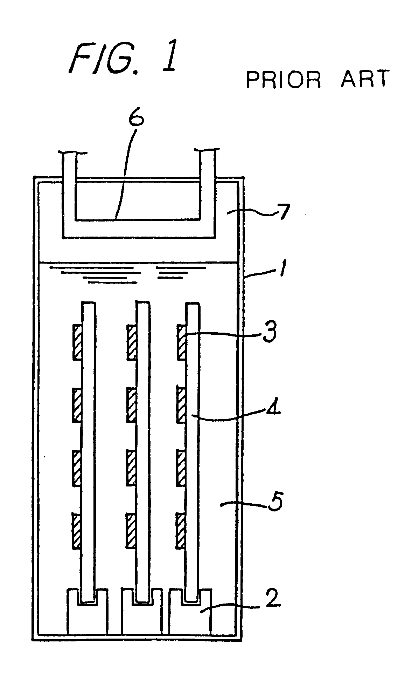

Evaporated coolant vapour must be liquefied again and circulated back to the cooling chamber. Therefore, efficiency of liquefaction of coolant vapour is also an important factor in improving the total efficiency of the cooling system. Usually the coolant vapour described above is liquefied by a second coolant such as chilled water running through a heat exchanger. An example of a typical immersion cooling chamber is shown schematically in Fig. 1. Circuit boards 4, made of ceramic for instance, carrying a plurality of IC chips 3 are supported by a connector 2, and immersed in a coolant 5 filled in a case 1. The evaporated coolant is liquefied again by a heat exchanger 6.

It is known in the art that the liquefaction efficiency is better when a heat exchanger 6 is placed in a space 7 above the coolant liquid 5 filled by the evaporated coolant vapour, than when it is placed in the coolant liquid. But there occurred a problem, when the heat exchanger is provided in a coolant vapour space; the liquefaction efficiency goes down gradually, and at last it comes to lose the cooling effect, so the system life is not good.

The reason is thought to be that in the liquid immersion cooling, there are many elements immersed in the coolant, such as IC chips, circuit boards, terminal boards forming a part of walls of the cooling chamber and so on. Various gases, mostly air and water vapour, are released from those elements and go up into the upper gas space 7 where the heat exchanger 6 is provided. Since those released gases are not liquefied by the heat exchanger, the released gases accumulate there and surround the heat exchanger. So, the liquefaction efficiency is decreased. In the cooling chamber, there are sealed various materials such as ceramics, semiconductors, insulating materials and so on, and the temperature can not be raised so high. Sometimes there might be a slow leak of the cooling chamber. Therefore, it is almost impossible by the present state-of-the-art technology to evacuate perfectly those gases before filling the cooling chamber with coolant. So, a degassing is necessary to take off such released gas repeatedly in order to keep a high cooling efficiency.

If the heat exchanger is immersed in the coolant liquid, above problem is avoided, but the coolant vapour must be liquefied by the coolant liquid itself, so the liquefaction efficiency goes down. Or the coolant must be cooler than its boiling point, so the heat elements are cooled merely by convection cooling, so the merit of evaporation cooling is lost.

One object of the present invention, therefore, is to improve the total efficiency of a cooling system for cooling a circuit board.

Another object of the present invention is to provide a cooling module for immersed cooling of circuit board, of which cooling efficiency is high and maintenance is easy.

Still another object of the present invention is to increase the reliability of circuit board cooling system.

According to the present invention a heat exchanger is immersed in a coolant liquid, and a bubble trap is provided above the heat exchanger but immersed in the coolant to trap the evaporated bubbles of the coolant and make them accumulate around the heat exchanger.

The bubble trap is made from porous metal. Various types of bubble traps are suggested.

The liquefaction efficiency of the heat exchanger is increased by the bubble traps, and since the heat exchanger is immersed in the coolant, it is separated from released gas that appears inevitably from various parts of the cooling module, and decreases the cooling efficiency of the heat exchanger if it accumulates around it. So, the cooling efficiency does not go down for a long period, and a degassing process is unnecessary; accordingly the maintenance becomes very easy.

According to another feature of the invention, a bubble guide is introduced. If the bubble traps, the bubble guide and heat exchanger are arranged properly, most of the evaporated coolant is liquefied before it reaches the liquid surface. Such motion of bubbles causes a local circulation of coolant that further increases the cooling efficiency and improves uniformity of temperature over the entire surface of the immersed circuit board.

A means is necessary to connect the circuit boards in the cooling module electrically to the outer circuits or equipment. For this purpose the cooling module of the present invention may be provided on its side wall with a plurality of sealed contact pins connecting between the inside and outside of the module. The inner circuit boards are connected through these contact pins to the outer circuits.

In another embodiment, the circuit board having contact pins is fixed to an opening of the cooling module with its surface carrying elements to be cooled facing the inside of the cooling chamber, and the circuit board itself forms a part of sealing wall of the module. If each of the circuit boards is fabricated in such a form, it is very convenient to assemble them as a module into an equipment or system.

According to another aspect of the present invention as defined in claim 7, heat exchangers are positioned beneath a circuit board.

These with other objects and advantages, which will be subsequently apparent, reside in the details of construction, as more fully hereinafter described and claimed, reference being had to the accompanying drawings forming a part hereof, wherein like numerals refer to like parts throughout.

Fig. 1 shows schematically a structure of a prior art cooling module which immerses circuit boards in coolant.

Fig. 2 is a schematic perspective view of a cooling module.

Fig. 3 is a schematic cross sectional view of the cooling module shown in Fig. 2.

Fig. 4 shows an enlarged partial view of Fig. 3.

Fig. 5 is a graph demonstrating an effect of the bubble traps indicating an improvement of cooling efficiency.

Fig. 6 is a graph showing an effect of a bubble guide, comparing the temperature of chips on a circuit board.

Fig. 7 illustrates an example of how cooling modules are assembled in a power dissipating equipment.

Fig. 8 is a schematic cross sectional view of a second embodiment showing another arrangement of bubble traps and heat exchangers.

Fig. 9 is a schematic front sectional view of a third embodiment which uses heat pipes as the heat exchanger.

Fig. 10 is a schematic diagram illustrating another embodiment of the present invention wherein the coolant is forced to circulate in a cooling module.

Throughout the drawings like reference numerals or symbols designate same or corresponding parts.

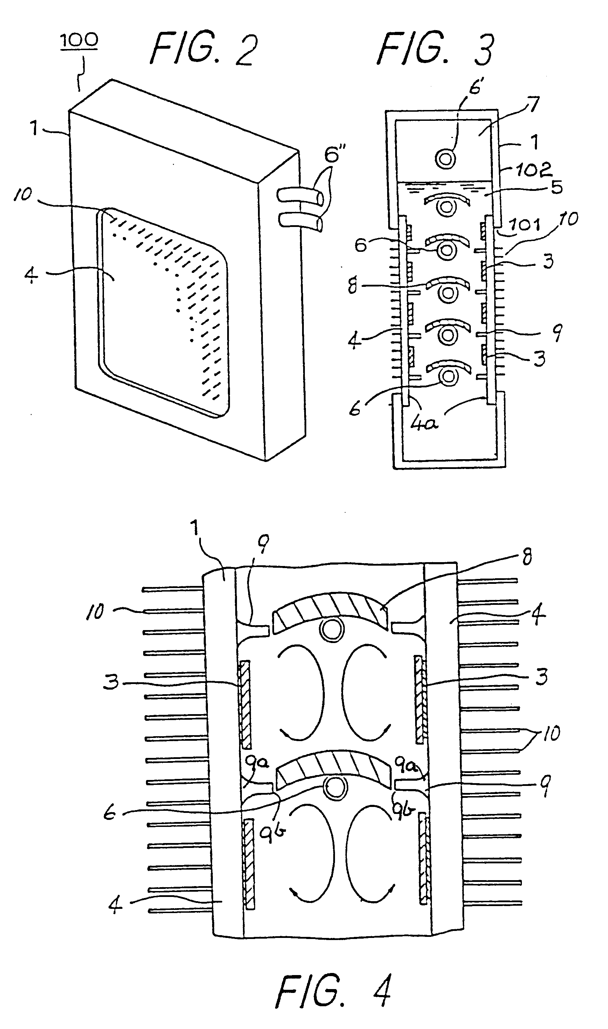

Referring first to Figures 2 and 3, metallic case 1 of the module 100 is provided with openings on both its sides, and ceramic circuit boards 4 carrying a plurality of IC chips 3 are placed at the openings and seal them hermetically. The ceramic circuit board 4 is usually made of multi-layered printed circuit boards, and its surface carrying the chips 3 faces the inside of the case. The case 1 is provided with pipes 6'' which are respectively an inlet and outlet of cooling water for heat exchangers 6 provided in the case 1.

The heat exchangers are shown in circular cross section in Fig. 3. Usually they have fringes or fins to make good contact with the coolant 5, but these are omitted for the sake of simplicity. The heat exchangers 6 are connected in series or parallel to each other in the case 1, and then they are connected to the inlet and outlet pipes 5 respectively. The coolant running through the heat exchangers 6 is usually chilled water which is available most easily, but of course it may be of any kind depending on temperature design or economy.

The heat exchangers 6 are immersed in the coolant liquid 5 except one 6' which is placed in an upper space 7 where the evaporated coolant and the released gas from various elements in the cooling chamber are collected. Over each of the heat exchangers 6 immersed in the coolant liquid is provided a bubble trap 8 as shown in Fig. 3. These bubble traps 8 collect evaporated bubbles of the coolant and make them contact the respective heat exchanger 6. So, most of the evaporated coolant bubbles are condensed and liquefied again by the heat exchangers 6 before they reach to the surface of the coolant. Only a small part of bubbles can reach the surface of the coolant liquid, but they are liquefied by the heat exchanger 6' placed in the upper space 7, and go back to the liquid.

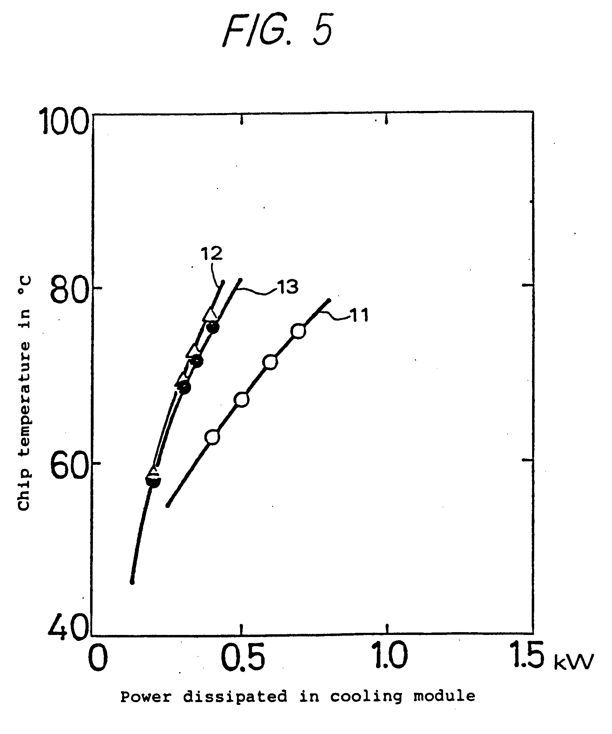

The shape of the bubble trap 8 is not critical. It may have a shape of a roof or downward concave as shown in the figure to collect the bubbles and make them concentrate around the heat exchanger 6. These shapes did not show significant difference between their efficiency of bubble condensation. But it was found by experiment that the bubble trap is made from porous material having preferably pores of approximately 0.5-0.6 mm in diameter corresponding to a porosity of 20 pores per $cm^3$. Such experiment will be discussed later with respect to Fig. 5.

Though the reason is still not perfectly clear, the inventors believe it to be as follows. If the trap is made from a non-porous material, the condition will become similar to that of the prior art as shown in Fig. 1. When it is made from a porous material, the released gas can escape to the upper space 7. On the contrary, too large holes will pass the bubbles easily, so the effect will be lost. The preferred porosity will depend on the viscosity of the coolant, bubble size and pressure etc. The preferred hole size, therefore, is small enough to prevent bubble leakage, but large enough to pass the liquid coolant.

The material for the bubble trap preferably has a good heat conductivity. Copper, aluminum and nickel have been tried. But no significant difference between them has been recognized. Such porous metal, having a sponge-like appearance, is available on the market under the trade name "Celmet" (manufactured by Sumitomo Denko).

With the cooling system of the present invention, the high efficiency of evaporation cooling is retained and the liquefaction efficiency is also kept high because the bubbles of the coolant are contacted directly to the heat exchangers, though they are immersed in the coolant. The degradation of cooling efficiency by the released gas is avoided since the heat exchangers are immersed in the coolant liquid and provided with a porous bubble trap, the released gas does not concentrate around the heat exchanger. The degassing process, therefore, is unnecessary for a long period, and the maintenance becomes very easy.

The effect of the bubble traps applied in IC chip cooling is demonstrated in Fig. 5. In the figure, the abscissa indicates power in kW dissipated by a circuit board having plenty of IC chips and immersed in a coolant; the ordinate is the temperature of the chip in °C. A curve 12 having measured points indicated by triangles shows the temperature variation of the IC chip on the circuit board when it is cooled in a module without bubble traps. A curve 11 having measured points indicated by white circles corresponds to that when the same circuit board is cooled in a module with bubble traps. As can be seen in the graph, the heat dissipation has been improved nearly twice by the bubble traps.

Effect of porosity of the bubble trap is also shown in Fig. 5. The curve 11 shows the temperature of the chip when bubble traps having a porosity of 20 pores per $cm^3$ is used, that is the size of the pore is approximately 0.5-0.6 mm. The curve 13 having measured points indicated by black circles shows the temperature of the chip when the bubble trap is made from a material having 10 pores per $cm^3$, that is the pore size is approximately 1.0-1.5 mm in diameter. During the measurement, 1.0 liters of cooling water per min. was run through the heat exchangers 6 immersed in the coolant liquid, and 0.5 liters per min. was run through the heat exchanger 6' in the upper space 7. As can be seen in the graph, the bubble trap with too large holes (curve 13) has almost no effect for improving the cooling effect. A material having a porosity of about from 15 to 50 pores per $cm^3$ is used as a bubble trap.

Going back to Fig. 3, the cooling module of this embodiment is provided with bubble guides 9. In this embodiment, the bubble guides 9 are provided on the circuit board between upper and lower IC chips 3. The circuit boards 4 are sealed in an opening 101 in the wall 102 of the case 1 and are also provided with contact pins 10 directed outward of the case 1. These pins are buried hermetically in the ceramic circuit board 4, and serve as a connection between the circuit board or ICs and outer circuits.

In Fig. 4 is shown a part of Fig. 3 enlarged illustrating a shape and positional relationship between the heat exchangers 6, the bubble traps 8 and the bubble guides 9. The bubble guide 9 is bulged at one end 9a and is attached to the circuit board 4 between the upper and lower IC chips 3. The other end 9b of the bubble guide 9 is aligned with the edge of the bubble trap 8. The evaporated bubbles of the coolant go up along the surface of the chips 3 or the surface of the circuit board 4.This could cause poor contact of the chips located on upper part of the circuit board with the coolant liquid, and decreases the cooling effect. But the bubble guide 9 separates the bubbles from the chip surface and guides them smoothly towards the bubble trap 8. Thus the bubbles appearing in one section of the IC chips are collected around a heat exchanger under corresponding bubble trap, before they go up to the upper section of the circuit board. So, the liquefaction of the coolant gas becomes more effective.

Motion of such bubbles causes a local convection current of coolant as shown by arrows in the figure. It has been observed in a cooling module with its case made of transparent plastic resin. Such local circulation of the coolant further increases the cooling efficiency and improves uniformity of the temperature on the circuit board. If such bubble guides are not provided, the flow of coolant becomes a long loop circulating from bottom of the case 1 to the surface of the liquid coolant causing an undesirable temperature distribution on the circuit board. Because the bubbles are accumulated at the upper portion of the circuit board, the cooling effect is lost. Accordingly, the cooling effect at the upper portion of the circuit board is decreased and the temperature of the IC chips on the upper part of the circuit board becomes high compared to that of lower part.

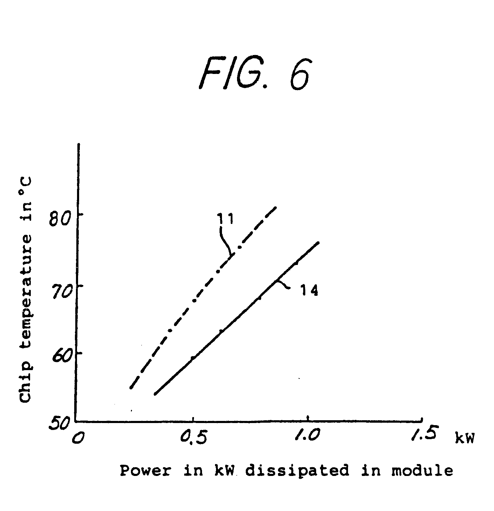

Fig. 6 shows the effect of the bubble guide. In the figure, the abscissa indicates power in kW dissipated by a circuit board, and the ordinate is a chip temperature in ° C. A curve 14 shows a variation of temperature of IC chips bonded on the circuit board which is provided with the bubble guides 9 when the power consumption in the circuit board is varied. The curve 11 (chained line) transferred from Fig. 5 is the temperature of chip bonded on a circuit board without bubble guides, to compare it with the curve 14. The temperature of the IC chip becomes lower when the bubble guides are provided compared to that when the bubble guides are not provided for the same power dissipation. Therefore, the effect of the bubble guide will be apparent.

The cooling case 1 may be made from any material, but it is preferably made from metal, because its elasticity can mitigate the deformation of the module caused by pressure and temperature variation. The cooling case as shown in Figs. 2 and 3 is very convenient for use in a large system, a large computer for example. Each module comprises two circuit boards having a plurality of IC chips having their coupling pins 10 directed to both sides. These contact pins can be used as a wiring pins between the circuit boards. There is no difference using contact pins of an ordinary circuit board. So, numerous such modules can be handled as an ordinary circuit board having a little larger thickness. But the total thickness of the two circuit boards is less, compared to that of other cooling methods, because the cooling effect is best compared to others. The volume of the total system also becomes smallest.

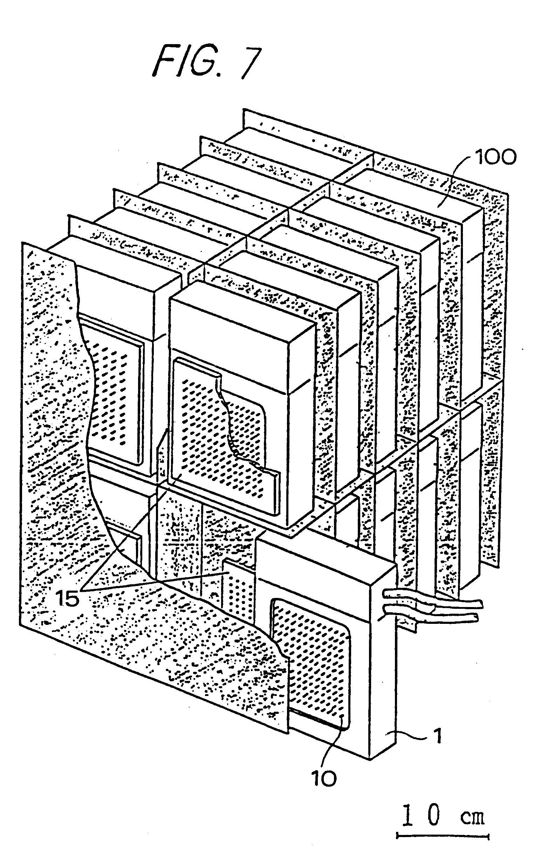

An example of an assembly of such cooling modules is illustrated in Fig. 7. A plurality of cooling modules 100 are stacked in a rack or cabinet, and the circuit boards 4 are wired to each other using their contact pins 10. High density connectors 15 may be used for interconnecting them; the assembly of these is similar to those of usual circuit board assembly. In the figure, connection of the cooling water pipe is omitted, because it is only intended to show an example of assembly of such modules.

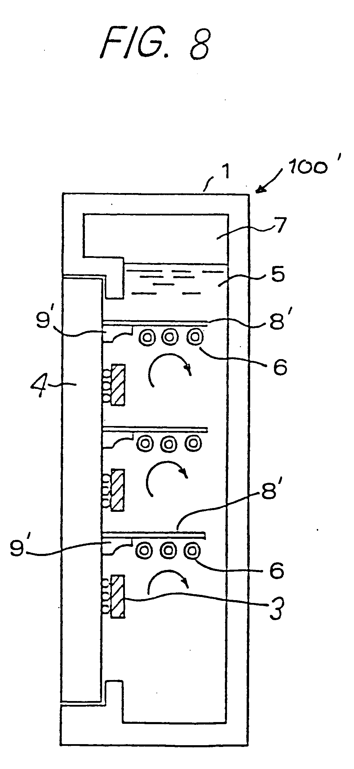

Various modifications of the above cooling module are possible. Fig. 8 shows a second embodiment.

In this embodiment, only one circuit board 4 is fitted to the case 1 of a cooling module 100' contact pins of the circuit board 4, and a heat exchanger provided in the upper space 7, are omitted in the figure for simplicity. Such configuration is applicable for a circuit board which consumes relatively large power. The IC chips 3 are bonded to the circuit board 4 leaving a little gap between them and the circuit board in order to contact with the coolant on its front and back surfaces, and are cooled from both surfaces. Such bonding is known as flip chip bonding for example. The bubble guide 9' supports the bubble trap 8' at its one end, and each bubble trap is provided with three heat exchangers 6 respectively. In this case, the shape of the bubble trap 8 is planar. And a local convection current of the coolant liquid 5 occurs as shown by arrows. The effect of the cooling is similar to that explained above.

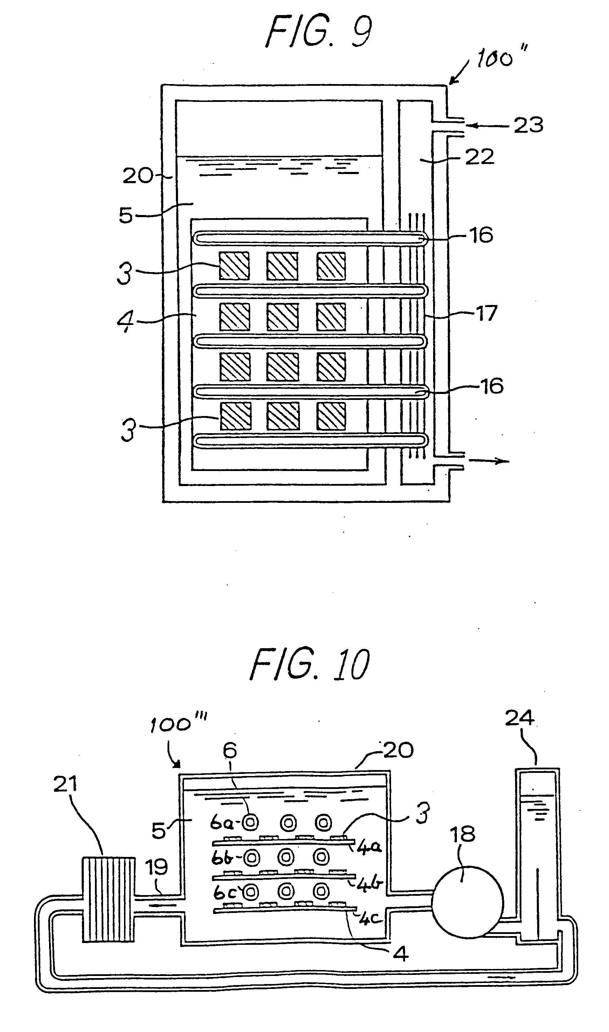

Fig. 9 is a schematic front sectional view of a third embodiment illustrating the main part of the cooling module 100''. In this embodiment, the heat exchangers are composed of heat pipes. The circuit board 4 carrying IC chips 3 is immersed in coolant liquid 5 sealed in a main cooling chamber 20. The heat pipe 16 is placed in the main cooling chamber 20 and plays the part of a heat exchanger. In the figure, the bubble traps and bubble guides are omitted for the sake of simplicity, but they must be provided in similar manner to that described before. The heat pipe 16 is extended from the main cooling chamber 20 to a sub cooling chamber 22, and it has fins 17 and is cooled by a second coolant 23 (usually it is chilled water) running through the sub cooling chamber 22. The coolant in the heat pipe and its pressure is chosen to be appropriate for heat transfer from the coolant 5 to the second coolant in the second cooling chamber 22. Such design of the heat pipe is conventional in the art, and since not relevant to the present invention, further description is omitted.

Fig. 10 illustrates schematically another embodiment of the present invention. In this embodiment, the coolant liquid 5 is circulated in a main chamber 20 of the cooling module 100''' by a pump 18. The circuit boards 4a, 4b, 4c carrying the chips 3 are placed horizontally in a coolant liquid 5. The circuit boards 4a, 4b, 4c play a role of bubble guides or traps, so it is unnecessary to provide the bubble trap and the bubble guide. The evaporated coolant bubbles are condensed by the heat exchangers provided underneath the circuit boards 6a, 6b, 6c, of which 6b and 6c are respectively 4a and 4b. In this case the local convection current of the coolant is unnecessary, since the coolant is forced to flow by the pump 18. The circulated coolant is taken out of the main chamber 20 through a pipe 19, and led to an external heat exchanger 21, where the remaining bubbles are liquefied perfectly and led to a gas extractor 24, where the remaining released gas is extracted. The coolant liquid is pressurized by a pump 18, and returned to the main cooling chamber 20.

As has been disclosed above, the cooling module by the present invention improves the cooling efficiency of the chips immersed in coolant by bubble trap and bubble guide. The effect of released gas is eliminated by immersing the heat exchanger in the coolant liquid. So the maintenance of the cooling system is simplified, eliminating the process of degassing.

Various modifications or variations of a cooling module described above are possible within the scope of the present invention.

## Claims

1. An evaporation cooling module (100, 100', 100'') for cooling a plurality of semiconductor chips (3) mounted on a circuit board (4) immersed in a coolant (5), comprising a case (1, 20) for sealing said coolant (5); one or more heat exchangers (6, 16) for cooling said coolant (5) and liquefying evaporated coolant vapour, said heat exchanger(s) (6, 16) being immersed in said coolant (5); bubble traps (8, 8') for collecting bubbles of evaporated vapour of said coolant and making them contact said heat exchanger(s) (6, 16), said bubble traps (8, 8') being immersed in said coolant (5) and bubble guides (9, 9') for guiding bubbles of evaporated coolant toward said bubble traps (8, 8'), said bubble guides (9, 9') being immersed in said coolant (5), said evaporation cooling module (100, 100', 100'') being characterised in that said bubble traps (8, 8') are positioned over said heat exchanger(s) (6, 16) and made from porous metal having a porosity within the range of approximately 15 to 50 pores per $cm^3$.

2. A cooling module (100, 100', 100'') according to claim 1, wherein said case (1) has an opening (101) in its side wall (102) for hermetically fixing said circuit board (4) with the surface (4a) carrying the chips (3) facing the inside of the case (1).

3. A cooling module (100, 100', 100'') according to claim 1 or claim 2, wherein said bubble guides (9, 9') are attached to said circuit board between upper and lower chips (3), said bubble guides (9, 9') having one edge (9b) aligned with one edge of the respective bubble traps (8).

4. A cooling module (100, 100', 100'') according to any preceding claim, wherein a bubble trap (8') attached at one end (9c') to a respective bubble guide (9'), and has a plurality of heat exchangers (6) beneath it.

5. A cooling module according to any preceding claim, wherein said heat exchangers is or are composed of a heat pipe or pipes (16) whereof one end protrudes from said case (20) and is cooled there by a second coolant (23) flowing outside said case (20).

6. A cooling module according to claim 2, wherein said circuit boards (4) are provided with a plurality of hermetically sealed contact pins (10) for connecting the circuit on the circuit board (4) to an outer circuit.

7. An evaporation cooling module (100'') for cooling a plurality of semiconductor chips (3) immersed in a forced circulated coolant (5), wherein said evaporation cooling module comprises:-
   a case (20) for sealing said coolant (5) and cooled objects in it;
   one or more circuit boards (4,4a,4b,4c) carrying a plurality of chips (3), said circuit boards(4,4a,4b,4c) being placed horizontally in said case (20), and being immersed in said coolant (5);
   a plurality of heat exchangers (6,6a,6b,6c) for cooling the coolant (5) and liquefying evaporated vapour of said coolant, said heat exchangers (6,6a,6b,6c) being immersed in said coolant (5), at least one of said heat exchangers (6b,6c) being positioned beneath a circuit board (4a,4b); and
   a pump (18) for circulating said coolant (5)

8. An evaporation cooling module (100''') according to claim 7, further comprising:
   an external heat exchanger (21) for liquefying evaporated vapour of said coolant included in said circulating coolant (5), said external heat exchanger (21) being provided outside said case (20); and
   a gas extractor (24) for extracting gas included in said circulating coolant (5).

9. A cooling module (100,100',100'',100''') according to any preceding claim, wherein said circuit boards (4,4a,4b,4c) are made from ceramic.

**Revendications**

1. Module (100, 100', 100'') de refroidissement par évaporation destiné au refroidissement de plusieurs pastilles semi-conductrices (3) montées sur une carte de circuit (4) qui est immergée dans un fluide de refroidissement (5), comprenant un boîtier (1, 20) destiné à enfermer le fluide de refroidissement (5), un ou plusieurs échangeurs de chaleur (6, 16) destinés à refroidir le fluide de refroidissement (5) et à liquéfier la vapeur du fluide de refroidissement, l'échangeur ou les échangeurs de chaleur (6, 16) étant immergés dans le fluide de refroidissement (5), des pièges à bulles (8, 8') destinés à collecter les bulles de vapeur du fluide de refroidissement et à les mettre au contact de l'échangeur ou des échangeurs de chaleur (6, 16), les pièges à bulles (8, 8') étant immergées dans le fluide de refroidissement (5) et des guides de bulles (9, 9') destinés à guider des bulles de fluide de refroidissement qui s'évaporent vers les pièges à bulles (8, 8'), les guides de bulles (9, 9') étant immergés dans le fluide de refroidissement (5), le module (100, 100', 100'') de refroidissement par évaporation étant caractérisé en ce que les pièges à bulles (8, 8') sont placés au-dessus de l'échangeur ou des échangeurs de chaleur (6, 16) et sont formés d'un métal poreux ayant une porosité comprise entre environ quinze et cinquante pores par centimètre cube.

2. Module de refroidissement (100, 100', 100'') selon la revendication 1, dans lequel le boîtier (1) a une ouverture (101) formée dans sa paroi latérale (102) et destinée à la fixation hermétique de la carte de circuit (4), la surface (4a) portant les pastilles (3) étant tournée vers l'intérieur du boîtier (1).

3. Module de refroidissement (100, 100', 100'') selon la revendication 1 ou 2, dans lequel les guides de bulles (9, 9') sont fixés à la carte de circuit entre les parties supérieures et inférieures (3), les guides de bulles (9, 9') ayant un bord (9b) aligné sur un bord des pièges respectifs à bulles (8).

4. Module de refroidissement (100, 100', 100'') selon l'une quelconque des revendications précédentes, dans lequel un piège à bulles (8') fixé à une première extrémité (9c') a un guide de bulles respectif (9') et a plusieurs échangeurs de chaleur (6) placés sous lui.

5. Module de refroidissement selon l'une quelconque des revendications précédentes, dans lequel les échangeurs de chaleur sont composés d'un ou plusieurs caloducs (16) dont une première extrémité dépasse du boîtier (20) et est refroidie par un second fluide de refroidissement (23) qui circule à l'extérieur du boîtier (20).

6. Module de refroidissement selon la revendication 2, dans lequel les cartes de circuit (4) ont plusieurs broches de contact (10) scellées hermétiquement et destinées à connecter le circuit de la carte (4) à un circuit externe.

7. Module (100'') de refroidissement par évaporation destiné au refroidissement de plusieurs pastilles semi-conductrices (3) immergées dans un fluide (5) de refroidissement à circulation forcée, dans lequel le module de refroidissement par évaporation comprend :

un boîtier (20) destiné à enfermer le fluide de refroidissement (5) et les objets refroidis placés à l'intérieur de manière étanche,

une ou plusieurs cartes de circuit (4, 4a, 4b, 4c) portant plusieurs pastilles (3), les cartes de circuit (4, 4a, 4b, 4c) étant placées horizontalement dans le boîtier (20) et étant immergées dans le fluide de refroidissement (5),

plusieurs échangeurs de chaleur (6, 6a, 6b, 6c) destinés à refroidir le fluide de refroidissement (5) et à liquéfier la vapeur du fluide de refroidissement qui s'est évaporé, les échangeurs de chaleur (6, 6a, 6b, 6c) étant immergés dans le fluide de refroidissement (5), l'un au moins des échangeurs de chaleur (6b, 6c) étant placé au-dessous d'une carte de circuit (4a, 4b), et

une pompe (18) destinée à faire circuler le fluide de refroidissement (5).

8. Module de refroidissement par évaporation (100'') selon la revendication 7, comprenant en outre :

un échangeur externe de chaleur (21) destiné à liquéfier la vapeur du fluide de refroidissement qui s'est évaporé, et compris dans le circuit de fluide de refroidissement (5), l'échangeur externe de chaleur (21) étant placé à l'extérieur du boîtier (20), et

un organe (24) d'extraction de gaz contenu dans le fluide de refroidissement (5) qui circule.

9. Module de refroidissement (100, 100', 100'', 100'') selon l'une quelconque des revendications précédentes, dans lequel les cartes de circuit (4, 4a, 4b, 4c) sont formées de céramique.

**Patentansprüche**

1. Verdampfungskühlmodul (100, 100', 100'') zum Kühlen einer Vielzahl von Halbleiterchips (3), die auf einer Schaltungskarte (4) montiert sind, die in ein Kühlmittel (5) eingetaucht ist mit einem Gehäuse (1, 20) zum Versiegeln des Kühlmittels (5); einem oder mehreren Wärmetauschern (6, 16) zum Kühlen des Kühlmittels (5) und zum Verflüssigen verdampften Kühlmitteldampfes, welche(r) Wärmetauscher (6, 16) in das Kühlmittel (5) eingetaucht sind; Blasenfallen (8, 8') zum Sammeln von Blasen des verdampften Kühlmitteldampfes und um sie (den) die Wärmetauscher (6, 16) kontaktieren zu machen, welche Blasenfallen (8, 8') in das Kühlmittel (5) eingetaucht sind, und Blasenführungen (9, 9') zum Führen von Blasen des verdampften Kühlmittels zu den Blasenfallen (8, 8'), welche Blasenführungen (9, 9') in das Kühlmittel (5) eingetaucht sind, welches Verdampfungskühlmodul (100, 100', 100'') dadurch gekennzeichnet ist, daß die Blasenfallen (8, 8') über dem(n) Wärmetauscher(n) (6, 16) angeordnet und aus porösem Metall hergestellt sind, welches eine Porösität im Bereich von etwa 15 bis 50 Poren pro cm$^3$ hat.

2. Kühlmodul (100, 100', 100'') nach Anspruch 1, bei dem das Gehäuse (1) eine Öffnung (101) in seiner Seitenwand (102) hat, um die Schaltungskarte (4) hermetisch mit der Oberfläche (4a) zu fixieren, welche die Chips (3) der Innenseite des Gehäuses (1) zugewandt trägt.

3. Kühlmodul (100, 100', 100'') nach Anspruch 1 oder 2, bei dem die Blasenführungen (9, 9') an der Schaltungskarte zwischen oberen und unteren Chips (3) befestigt ist, welche Blasenführungen (9, 9') einen Rand (9b) haben, der mit einem Rand der entsprechenden Blasenfallen (8) ausgerichtet ist.

4. Kühlmodul (100, 100', 100'') nach einem der vorhergehenden Ansprüche, bei dem eine Blasenfalle (8') an einem Ende (9c') an einer entsprechenden Blasenführung (9') befestigt ist und eine Vielzahl von Wärmetauschern (6) darunter hat.

5. Kühlmodul nach einem der vorhergehenden Ansprüche, bei dem der oder die Wärmetauscher aus einem oder mehreren Wärmeleitungsrohren (16) besteht, von denen ein Ende von dem Gehäuse (20) vorsteht und dort durch ein zweites Kühlmittel (23), das außerhalb des Gehäuses (20) fließt, gekühlt wird.

**6.** Kühlmodul nach Anspruch 2, bei dem die Schaltungskarten (4) mit einer Vielzahl von hermetisch versiegelten Kontaktstiften (10) versehen sind, um die Schaltung auf der Schaltungskarte (4) mit einer äußeren Schaltung zu verbinden.

**7.** Verdampfungskühlmodul (100'') zum Kühlen einer Vielzahl von Halbleiterchips (3), die in ein zwangsweise zirkuliertes Kühlmittel (5) eingetaucht sind, bei dem das Verdampfungskühlmodul umfaßt:-

ein Gehäuse (20), um das Kühlmittel (5) und in ihm gekühlte Objekte aufzunehmen;

eine oder mehrere Schaltungskarten (4, 4a, 4b, 4c), die eine Vielzahl von Chips (3) tragen, welche Schaltungskarten (4, 4a, 4b, 4c) horizontal in dem Gehäuse (20) angeordnet und in das Kühlmittel (5) eingetaucht sind;

eine Vielzahl von Wärmetauschern (6, 6a, 6b, 6c) zum Kühlen des Kühlmittels (5) und Verflüssigen verdampften Kühlmitteldampfes, welche Wärmetauscher (6, 6a, 6b, 6c) in das Kühlmittel (5) eingetaucht sind, wobei wenigstens einer der Wärmetauscher (6b, 6c) unterhalb einer Schaltungskarte (441, 4b) positioniert ist; und

eine Pumpe (18) zum Zirkulieren des Kühlmittels (5).

**8.** Verdampfungskühlmodul (100''') nach Anspruch 7, ferner mit:

einem externen Wärmetauscher (21) zum Verflüssigen verdampften Kühlmitteldampfes, das in dem zirkulierenden Kühlmittel (5) enthalten ist, welcher externe Wärmetauscher (21) außerhalb des Gehäuses (20) vorgesehen ist; und

einen Gasextraktor (24), zum Extrahieren von Gas, das in dem zirkulierenden Kühlmittel (5) enthalten ist.

**9.** Kühlmodul (100, 100', 100'', 100''') nach einem der vorhergehenden Ansprüche, bei dem die Schaltungskarten (4, 4a, 4b, 4c) aus Keramik hergestellt sind.

# FIG. 1

PRIOR ART

FIG. 2

FIG. 3

FIG. 4

## F/G. 5

Chip temperature in °C

Power dissipated in cooling module

FIG. 6

FIG. 7

100

15

1

10

1 0 cm

# FIG. 8

## FIG. 9

## FIG. 10